# EUROPÄISCHE PATENTSCHRIFT

(11) **EP 0 476 308 B1**
(45) Veröffentlichungstag und Bekanntmachung des Hinweises auf die Patenterteilung: **12.03.1997**
(21) Anmeldenummer: 91113685.1
(22) Anmeldetag: 14.08.1991
(51) Int. Cl.: H01L 29/732, H01L 29/737, H01L 29/417, H01L 29/423, H01L 29/06

(54) **Bipolartransistor für hohe Leistung im Mikrowellenlängenbereich**
Bipolar transistor for high power in the microwave range
Transistor bipolaire pour fortes puissances en hyperfréquence

(30) Priorität: 20.09.1990 DE 4029818
(43) Veröffentlichungstag der Anmeldung: 25.03.1992
(73) Patentinhaber: SIEMENS AKTIENGESELLSCHAFT, 80333 München (DE)
(72) Erfinder: Tews, Helmut, Dr. Dipl.-Phys., W-8025 Unterhaching (DE); Zwicknagl, Peter, Dr. Dipl.-Phys., W-7000 Stuttgart 80 (DE)

(56) Entgegenhaltungen:
- EP-A- 0 309 784
- EP-A- 0 326 828
- 1989 IEEE MTT-S Digest, S. 1061-4 (Wang et al.)

## Beschreibung

Die vorliegende Erfindung betrifft einen Leistungstransistor für den Mikrowellenlängenbereich gemäß dem Oberbegriff des Anspruches 1.

Leistungstransistoren werden in der Regel als Strukturen mit mehreren streifenförmigen Emitterzuleitungen ("Multi-Emitterfinger-Strukturen") ausgeführt (s. z. B. G.W. Wang et al.: "Design Optimization of Microwave Power Heterojunction Bipolar Transistor Cells", 1989 IEEE MTT-S Digest, 1061 - 1064 und A. P. Long et al.: "2.5 W, C-Band, GaAs/AlGaAs Heterojunction Bipolar Power Transistor", Electr. Lett. 25, 979 - 981 (1989)). Beim Heterobipolartransistor führt der beobachtete thermische Widerstand zu erhöhten Arbeitstemperaturen im Vergleich zu MESFET-Leistungstransistoren. Dadurch wird die CW-Leistungsabgabe signifikant begrenzt. Die hohen Durchbruchsspannungen am Heterobipolartransistor und die Möglichkeit, Ströme hoher Stromstärken zu handhaben, können deshalb nicht optimal ausgenutzt werden. Wünschenswert sind Leistungstransistoren, die bis zu Frequenzen im Mikrowellenlängenbereich (10 bis 100 GHz) mit hohen Leistungen (z. B. 5 W bei 30 GHz) betrieben werden können.

Aufgabe der vorliegenden Erfindung ist es, einen Leistungstransistor für Anwendung im Mikrowellenlängenbereich anzugeben, der einfach herstellbar ist und bei hoher Leistungsabgabe eine niedrige Arbeitstemperatur beibehält.

Diese Aufgabe wird mit dem Leistungstransistor mit den Merkmalen des Anspruches 1 gelöst. Weitere Ausgestaltungen ergeben sich aus den Unteransprüchen.

Bei der vorliegenden Erfindung ist der Leistungstransistor in der Form eines Array aus einer Vielzahl kleiner selbstjustierter symmetrischer Emitter-Basis-Bereiche (Emitter-Basis-Komplex, innerer Transistor) aufgebaut. Der innere Transistor, d. h. der Basis-Emitter-Komplex, wird je nach dem gewünschten Mikrowellenlängenbereich bemessen. Die kleinen Emitter-Bereiche bzw. Emitter-Basis-Bereiche ermöglichen eine Reduzierung der Basis-Emitter-Kapazität und der Basis-Kollektor-Kapazität und führen zu einer Verringerung der Emitter- und Kollektorladezeiten im Transistor. Diese Vielzahl kleiner Emitter-Basis-Komplexe wird erfindungsgemäß gemeinsam durch streifenförmige Zuleitungen elektrisch miteinander verbunden. Diese Zuleitungen führen jeweils zu Anschlußflächen auf der Oberfläche des Leistungstransistors. Jeder Emitter-Basis-Komplex ist ringsum durch einen Kollektortrenngraben, wie er in der europäischen Anmeldung EP 0416166 beschrieben ist, begrenzt. Diese Kollektorgräben reichen von der Oberfläche des Leistungstransistors bis in eine Subkollektorschicht. Über diese Subkollektorschicht erfolgt die Stromzuführung in die eigentliche Kollektorschicht der einzelnen Transistoren. Die Kollektorgräben, die die Emitter-Basis-Bereiche allseitig umgeben, sind mit einer Passivierung aus einem dielektrischen Material aufgefüllt. Die Kollektormetallisierung ist als Metallschicht auf diese Subkollektorschicht aufgebracht. Die einzelnen Kollektorgräben und der jeweilige Bereich der von ihnen umschlossenen Basis-Emitter-Bereiche bilden Aussparungen in dieser im übrigen ganzflächig aufgebrachten Kollektormetallisierung. Diese Kollektormetallisierung hat daher eine netzförmige Struktur und reicht jeweils ringsum bis an die Kollektorgräben heran. Auf diese Weise bewirkt diese Kollektormetallisierung, daß die in den einzelnen Transistoren erzeugte Wärme sehr gut über diese Kollektormetallisierung abgeleitet wird. Die Kollektor-Kontaktfläche befindet sich außerhalb des von dem Leistungstransistor-Array eingenommenen Bereiches auf der Schicht der Kollektormetallisierung oder einer weiteren darauf aufgebrachten Metallschicht.

Es folgt eine Beschreibung des erfindungsgemäßen Leistungstransistors anhand der Figuren 1 bis 6.
- Fig. 1: zeigt die erfindungsgemäße Anordnung in der Aufsicht
- Fig. 2: zeigt eine alternative erfindungsgemäße Anordnung in der Aufsicht.
- Die Fig. 3 bis 6: zeigen den erfindungsgemäßen Leistungstransistor im Querschnitt jeweils nach verschiedenen Schritten der Herstellung.

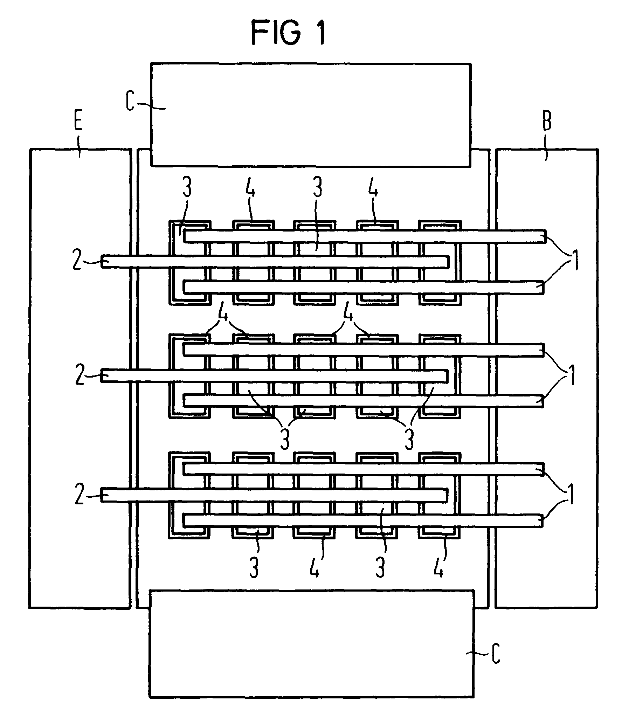

Fig. 1 zeigt eine Anordnung aus 15 in drei Reihen angeordneten Transistoren. Unter dem Emitter-Basis-Komplex 3 liegt jeweils der eigentliche Kollektor. Jeder Emitter-Basis-Komplex 3 ist durch einen Kollektorgraben 4 von dem Subkollektor, d. h. dem Kollektoranschluß getrennt. Trennbereiche, die die Emitter-Basis-Komplexe umgeben, können statt durch diese Kollektorgräben durch Spacer gebildet werden. Die Emittermetallisierungen werden über Emitterzuleitungen 2 elektrisch mit der Emitter-Kontaktfläche E verbunden. Entsprechend werden die Basis-Metallisierungen über Basiszuleitungen 1 mit der Basis-Kontaktfläche B elektrisch verbunden. In dem Beispiel der Fig. 1 sind für jede Reihe von Transistoren jeweils zwei Basiszuleitungen 1 (Basisfinger) und eine Emitterzuleitung 2 (Emitterfinger) vorhanden. Entsprechend ist eine Anordnung des Emitter-Basis-Komplexes mit je zwei Emitterzuleitungen 2 und je einer Basiszuleitung 1 für jede Reihe von Transistoren möglich. Zweckmäßig werden diese Basiszuleitungen und Emitterzuleitungen direkt auf die für die Kontaktierung vorgesehenen Bereich der Basisschichten bzw. Emitterschichten aufgebracht, so daß diese Basiszuleitungen 1 und Emitterzuleitungen 2 gleichzeitig die eigentliche Basismetallisierung bzw. Emittermetallisierung bilden. Zwischen den einzelnen Transistoren, also insbesondere in dem Bereich außerhalb der von den Kollektorgräben 4 umgebenen Bereiche werden die Basiszuleitungen 1 und die Emitterzuleitungen 2 über eine elektrisch isolierende Passivierung aus einem dielektrischen Material geführt, um die metallischen Zuleitungen von dem darunterbefindlichen Halbleitermaterial zu isolieren.

Die Anzahl der inneren Transistoren, die jeweils durch eine Basiszuleitung 1 bzw. eine Emitterzuleitung 2 miteinander elektrisch verbunden sind, wird durch den zulässigen Spannungsabfall zwischen dem ersten und dem letzten Transistor einer solchen Reihe längs der Basiszuleitungen bzw. der Emitterzuleitung bestimmt. Ein erfindungsgemäßes Array kann im Prinzip aus einer beliebigen Anzahl solcher Reihen von einzelnen Transistoren bestehen, wobei allerdings der Abstand zwischen den Reihen bei der Bemessung des Transistors auch eine Rolle spielt. Die inneren Transistoren sind in den Bereichen jeweils außerhalb der von den Kollektorgräben 4 umgebenen Bereiche auf der Höhe der Kollektorschicht, d. h. unmittelbar auf der Subkollektorschicht mit dem Netzwerk der vergrabenen, d. h. mit einer Passivierung bedeckten Kollektormetallisierung umgeben. Die Kollektormetallisierung ist zur Kontaktierung der Kollektoren der inneren Transistoren über die Subkollektorschicht und zur raschen Wärmeabfuhr und Wärmeverteilung im Array vorgesehen. Die Stromzuführung zu den Kollektoren erfolgt über die Kollektor-Anschlußfläche C.

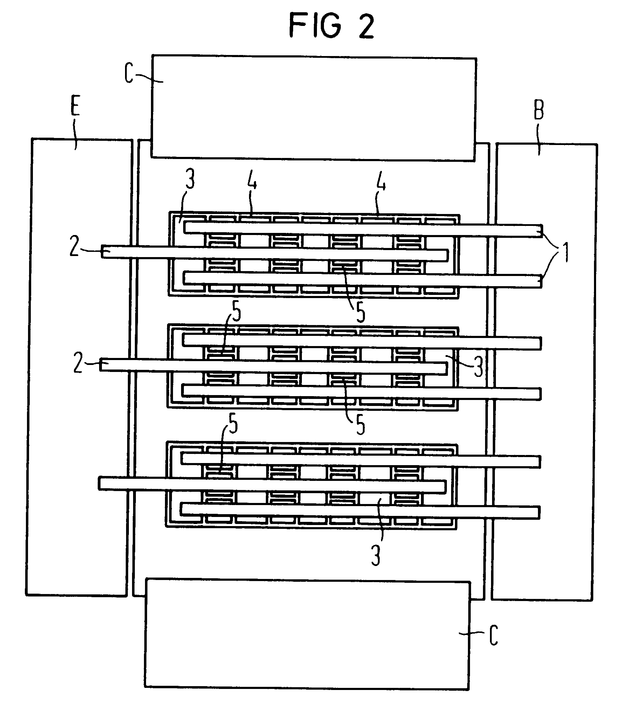

Fig. 2 zeigt eine alternative Ausführungsform ebenfalls in der Aufsicht. In dieser Variante sind die parasitären Leitungskapazitäten zwischen den inneren Transistoren einer Reihe nochmals reduziert. Zusätzlich zu den Kollektorgräben 4 sind hierbei Zwischengräben 5 vorgesehen. Diese Zwischengräben 5 verlaufen zu beiden Seiten der Basiszuleitungen 1 und der Emitterzuleitungen 2 und sind parallel zu diesen Zuleitungen jeweils in den Bereichen zwischen zwei aufeinanderfolgenden Transistoren angeordnet. Die Zwischengräben 5 reichen bis auf das Substrat 10. Die Zwischengräben 5 sind bevorzugt mit einer isolierenden Passivierung aufgefüllte ausgeätzte Gräben oder grabenförmige durch eine Implantation semiisolierend gemachte Bereiche des Halbleitermateriales. Es kann sich bei diesen zusätzlichen Isolationsbereichen statt um Gräben auch um ganzflächig mit dielektrischem Material gefüllte Gebiete handeln. Die Kollektormetallisierung ist in den von den Zwischengräben 5 umschlossenen Bereichen ausgespart. Die Stromzuführung zu den Kollektoren sowie die Ableitung und Verteilung der entstehenden Wärme erfolgt über die Kollektormetallisierung im Bereich zwischen den Reihen der Transistoren.

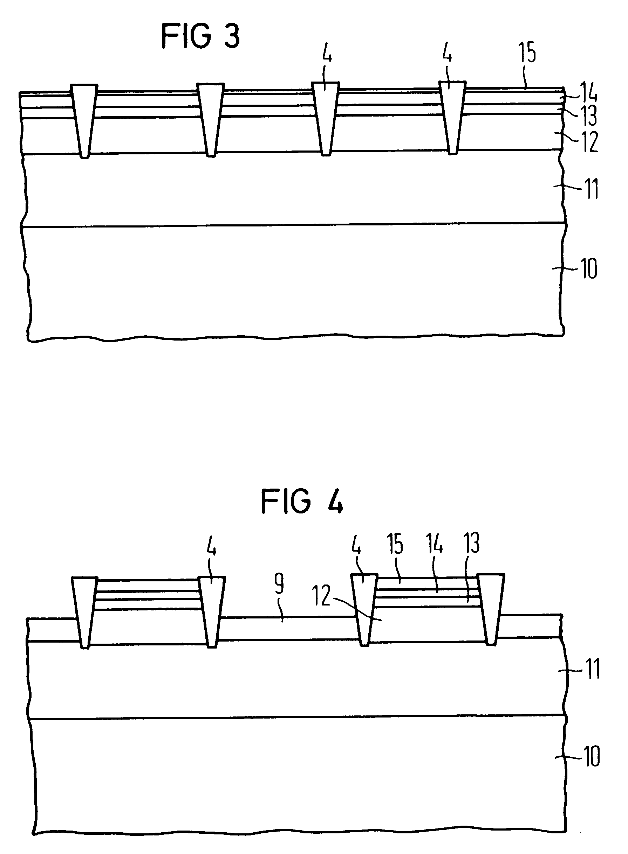

Eine besonders vorteilhafte Ausführungsform des erfindungsgemäßen Leistungstransistors läßt sich wie in den Figuren 3 bis 6 im Querschnitt dargestellt herstellen. Auf ein Substrat 10 werden die Subkollektorschicht 11, die Kollektorschicht 12, die Basisschicht 13, die Emitterschicht 14 und die Emitter-Kontaktschicht 15 aufgewachsen. Kollektorgräben als Trennbereiche 4 für die herzustellenden Emitter-Basis-Komplexe werden mittels Trockenätzens oder naßchemischen Ätzens hergestellt. In der Fig. 3 sind diese Trennbereiche 4 mit einer Passivierung aus einem elektrisch isolierenden Material (z. B. Si₃N₄) gefüllt und planarisiert. In der Tiefe reichen die ausgeätzten Kollektorgräben mindestens bis zur Oberfläche der überwachsenen Subkollektorschicht 11.

Die Schichtfolge wird außerhalb der von den Trennbereichen 4 umgebenen Bereichen bis zur Subkollektorschicht 11 hin abgetragen. Die Oberfläche der Subkollektorschicht 11 wird dann mit der Kollektormetallisierung 9 bedeckt. Diese Kollektormetallisierung 9 wird bis an die Trennbereiche 4 heranreichend aufgebracht.

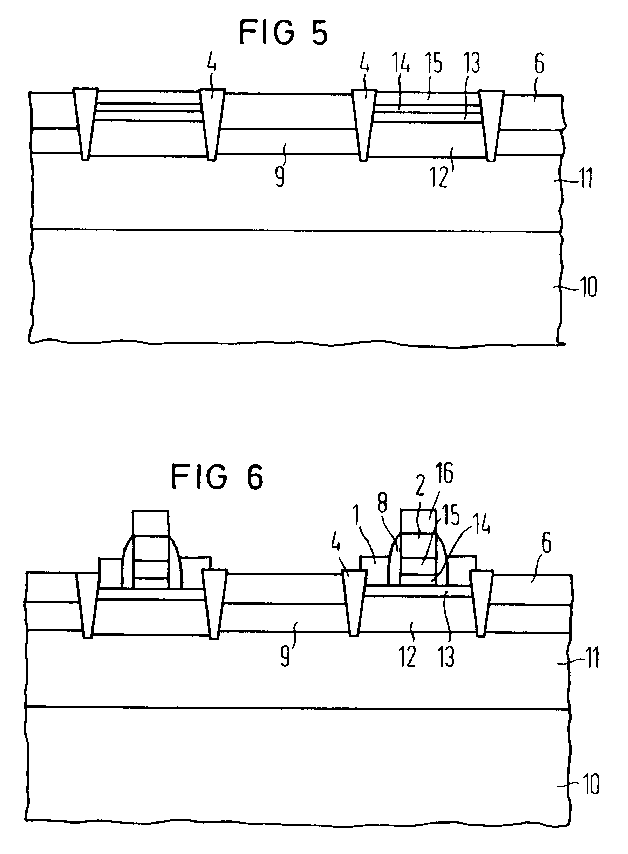

Auf die Kollektormetallisierung 9 wird, wie in Fig. 5 dargestellt, eine Passivierung 6 aus einem dielektrischen Material (z. B. Si₃N₄) aufgebracht. Die Zwischenräume zwischen den Emitter-Basis-Komplexen wird mit dieser Passivierung aufgefüllt und die Oberfläche planarisiert. Hierdurch erhält man ein vergrabenes thermisch und elektrisch gut leitendes Netzwerk aus Metall mit einem sehr guten Wärmekontakt zu den einzelnen Transistoren. Wichtig ist dabei, daß die Streifenbreite der Metallisierung so groß gewählt werden kann, daß eine Wärmemenge, wie sie im Betrieb eines Leistungstransistors üblicherweise entsteht, dadurch abgeleitet werden kann.

Fig. 6 zeigt einen Querschnitt durch einen fertigen erfindungsgemäßen Leistungstransistor. In diesem Querschnitt sind zwei Emitter-Basis-Komplexe des Arrays mit einer selbstjustierten Anordnung von Basisanschluß 1 und Emitteranschluß 2 dargestellt. Eine mögliche Herstellung dieses selbstjustierten Emitter-Basisgebietes ist folgende: Nach dem Aufbringen der Emitterzuleitung 2 wird erst die Emitter-Kontaktschicht 15 selektiv mit einem Trockenätzschritt bis zur Emitterschicht 14 geätzt, dann die Emitterschicht 14 bis zur Basisschicht 13 geätzt. Die Emitterzuleitung 2 und die Emitter-Kontaktschicht 15 sowie die Emitterschicht 14 werden mit einem Spacer 8 aus elektrisch isolierendem Material seitlich versehen. Nun wird über die freiliegende Basisschicht 14, den Spacer 8 und die Emitterzuleitung 2 die Basiszuleitung 1 aufgebracht und mit einem Planarisierungslack eingeebnet. Planarisierungslack und ein Teil der Basiszuleitung werden soweit zurückgeätzt (z. B. mit ECR-RIE), bis durch den Spacer 8 die elektrische Trennung von Basiszuleitung 1 und der Emitterzuleitung 1 mit einem darauf verbleibenden restlichen Anteil 16 der Basiszuleitung erreicht ist. In einer alternativen Ausführungsform können die Basis-Metallisierungen und Emitter-Metallisierungen auch gesondert aufgebracht und anschließend mit Basiszuleitungen 1 und Emitterzuleitungen 2 elektrisch leitend miteinander verbunden werden.

Die beschriebene Herstellung des erfindungsgemäßen Leistungstransistors ist sowohl mit dem bei Leistungstransistoren üblichen Rückseitenprozeß als auch mit einem Vorderseitenprozeß kompatibel. Für höhere Leistungen können mehrere erfindungsgemäße Transistor-Arrays zusammengeschaltet werden. Das erfindungsgemäße Transistor-Array ist ohne Einschränkung für alle Halbleiterschichtsysteme, die bei Heterobipolartransistoren üblich sind, realisierbar (z. B. AlGaAs/GaAs, InGaAs/InP, SiGe/Si usw.).

Besondere Vorteile des erfindungsgemäßen Leistungstransistors sind:
1. Bessere Hochfrequenzeigenschaften: die Transitfrequenz des erfindungsgemäßen Leistungstransistors ist größer als bei herkömmlichen Leistungstransistoren und die maximale Oszillatorfrequenz ist bei dem erfindungsgemäßen Aufbau sehr viel größer als bei herkömmlichen Leistungstransistoren.
2. Bei dem erfindungsgemäßen Aufbau handelt es sich um eine dezentrale, verteilte Anordnung von vielen kleinen Wärmequellen, von denen die entstehende Wärme besser abgeleitet werden kann als von einer einzigen, räumlich weit ausgedehnten Wärmequelle.

Der erfindungsgemäße Leistungstransistor verringert parasitäre Kapazitäten auf ein Minimum und garantiert zumindest näherungsweise gleiche Betriebsbedingungen für alle inneren Transistoren, die in dem Array zusammengeschaltet sind. Gleichzeitig wird die im Betrieb entstehende Wärme gleichmäßig verteilt und effektiv abgeführt.

## Patentansprüche

1. Leistungstransistor für den Mikrowellenlängenbereich mit einer Subkollektorschicht (11), mit einer Basis-Kontaktfläche (B), mit einer Emitter-Kontaktfläche (E) und mit einer Kollektor-Kontaktfläche (C), bei dem eine Mehrzahl von jeweils eine Kollektorschicht (12), eine Basisschicht (13) und eine Emitterschicht (14) aufweisenden Emitter-Basis-Komplexen (3) vorhanden ist, die in der Form eines Arrays in einer oder mehreren Reihen angeordnet sind,
jeder Emitter-Basis-Komplex (3) von einem bis in die Subkollektorschicht (11) reichenden Trennbereich (4) umgeben ist, streifenförmige Basiszuleitungen (1), die jeweils eine elektrische Verbindung der Basis jedes Emitter-Basis-Komplexes (3) einer Reihe von Emitter-Basis-Komplexen mit der Basis-Kontaktfläche (B) bilden, vorhanden sind,
streifenförmige Emitterzuleitungen (2), die jeweils eine elektrische Verbindung des Emitters jedes Emitter-Basis-Komplexes (3) einer Reihe von Emitter-Basis-Komplexen mit der Emitter-Kontaktfläche (E) bilden, vorhanden sind,
auf der Subkollektorschicht (11) eine Kollektormetallisierung (9) außerhalb der von den Trennbereichen (4) umgebenen Bereiche aufgebracht ist, und
diese Kollektormetallisierung (9) bis an jeden Trennbereich (4) heranreicht.

2. Leistungstransistor nach Anspruch 1, bei dem
die Emitter-Basis-Komplexe (3) jeweils eine Emitter-Kontaktschicht (15), eine Basismetallisierung (1) und eine Emittermetallisierung (2) aufweisen,
die Emittermetallisierung (2) von der Basismetallisierung (1) durch Spacer (8) getrennt ist und
die Kollektormetallisierung (9) mit einer Passivierung (6) bedeckt ist.

3. Leistungstransistor nach Anspruch 1 oder 2, bei dem
die Trennbereiche (4) Gräben sind.

4. Leistungstransistor nach Anspruch 3, bei dem
die Trennbereiche (4) mit einer Passivierung aus einem dielektrischen Material aufgefüllt sind.

5. Leistungstransistor nach Anspruch 1 oder 2, bei dem
die Trennbereiche (4) durch semiisolierende Bereiche im Halbeitermaterial gebildet sind.

6. Leistungstransistor nach Anspruch 1, bei dem
die Trennbereiche (4) durch Spacer gebildet sind, die die Emitter-Basis-Komplexe (3) ringsum begrenzen und die aus einem dielektrischen Material sind.

7. Leistungstransistor nach einem der Ansprüche 1 bis 6, angeordnet auf einem semiisolierenden Substrat (10), bei dem auf beiden Seiten der Basiszuleitungen (1) und parallel zu den Basiszuleitungen (1) verlaufend weitere Trennbereiche (5) vorhanden sind, die bis zum semiisolierenden Substrat (10) reichen,
auf beiden Seiten der Emitterzuleitungen (2) und parallel zu den Emitterzuleitung (2) verlaufend weitere Trennbereiche (5) vorhanden sind und
diese weiteren Trennbereiche jeweils zwischen zwei längs einer Basiszuleitung (1) aufeinanderfolgenden Emitter-Basis-Komplexen (3) angeordnet sind und jeweils bis an die diese Emitter-Basis-Komplexe (3) umgebenden Trennbereiche (4) heranreichen.

8. Leistungstransistor nach Anspruch 7, bei dem
die weiteren Trennbereiche (5) in der gleichen Art wie die Trennbereiche (4) ausgebildet sind.

9. Leistungstransistor nach Anspruch 7, bei dem
die von den weiteren Trennbereichen (5) umschlossenen Gebiete ganzflächig mit dielektrischem Material aufgefüllt sind.

## Claims

1. Power transistor for the microwave range, having a subcollector layer (11), having a base contact area (B), having an emitter contact area (E) and having a collector contact area (C), in which a plurality of emitter/base complexes (3) are present which each have a collector layer (12), a base layer (13) and an emitter layer (14) and are arranged in the form of an array in one or more rows, each emitter/base complex (3) is surrounded by an isolation region (4) which reaches down into the subcollector layer (11), base supply lines (1) in strip form are present which each form an electrical connection between the base of each emitter/base complex (3) of a row of emitter/base complexes and the base contact area (B), emitter supply lines (2) in strip form are present which each form an electrical connection between the emitter of each emitter/base complex (3) of a row of emitter/base complexes and the emitter contact area (E), a collector metallization layer (9) is applied to the subcollector layer (11) outside the regions surrounded by the isolation regions (4), and this collector metallization layer (9) reaches up to each isolation region (4).

2. Power transistor according to Claim 1, in which the emitter/base complexes (3) each have an emitter contact layer (15), a base metallization layer (1) and an emitter metallization layer (2), the emitter metallization layer (2) is isolated from the base metallization layer (1) by spacers (8), and the collector metallization layer (9) is covered with a passivation layer (6).

3. Power transistor according to Claim 1 or 2, in which the isolation regions (4) are trenches.

4. Power transistor according to Claim 3, in which the isolation regions (4) are filled with a passivation layer made of a dielectric material.

5. Power transistor according to Claim 1 or 2, in which the isolation regions (4) are formed by semi-insulating regions in the semiconductor material.

6. Power transistor according to Claim 1, in which the isolation regions (4) are formed by spacers which delimit the emitter/base complexes (3) all around and are made of a dielectric material.

7. Power transistor according to one of Claims 1 to 6, arranged on a semi-insulating substrate (10), in which further isolation regions (5) are present running on both sides of the base supply lines (1) and parallel to the base supply lines (1), which isolation regions (5) reach down to the semi-insulating substrate (10), further isolation regions (5) are present running on both sides of the emitter supply lines (2) and parallel to the emitter supply lines (2), and these further isolation regions are in each case arranged between two emitter/base complexes (3), following one another along a base supply line (1), and in each case reach up to the isolation regions (4) surrounding these emitter/base complexes (3).

8. Power transistor according to Claim 7, in which the further isolation regions (5) are designed in the same way as the isolation regions (4).

9. Power transistor according to Claim 7, in which the regions enclosed by the further isolation regions (5) are filled over the whole area with dielectric material.

## Revendications

1. Transistor de puissance pour la gamme des hyperfréquences avec une couche de sous-collecteur (11), avec une surface de contact de base (B), avec une surface de contact d'émetteur (E) et avec une surface de contact de collecteur (C), dans lequel une pluralité de complexes émetteur-base (3), présentant une couche de collecteur (12), une couche de base (13) et une couche d'émetteur (14), est présente, lesdits complexes étant disposés sous la forme d'un array dans une ou plusieurs rangées,
chaque complexe émetteur-base (3) est entouré d'une zone de séparation (4) s'étendant jusque dans la couche du sous-collecteur (11), des lignes d'alimentation de base (1) en forme de bande, qui forment à chaque fois une liaison électrique de la base de chaque complexe émetteur-base (3) d'une rangée de complexes émetteur-base avec la surface de contact de base (B),
des lignes d'alimentation d'émetteur (2) en forme de bande, qui forment à chaque fois une liaison électrique de l'émetteur de chaque complexe émetteur-base (3) d'une rangée de complexes émetteur-base avec la surface de contact d'émetteur (E), sont présentes,
sur la couche de sous-collecteur (11), une métallisation du collecteur (9) est appliquée à l'extérieur des zones entourées par les zones de séparation (4), et
cette métallisation du collecteur (9) s'étend jusqu'à chaque zone de séparation (4).

2. Transistor de puissance selon la revendication 1, dans lequel
les complexes émetteur-base (3) présentent à chaque fois une couche de contact d'émetteur (15), une métallisation de base (1) et une métallisation d'émetteur (2),
la métallisation d'émetteur (2) est séparée de la métallisation de base (1) par une pièce d'écartement (8) et
la métallisation du collecteur (9) est recouverte d'une passivation (6).

3. Transistor de puissance selon les revendications 1 ou 2, dans lequel les zones de séparation (4) sont des tranchées.

4. Transistor de puissance selon la revendication 3, dans lequel les zones de séparation (4) sont remplies d'une passivation composée d'un matériau diélectrique.

5. Transistor de puissance selon les revendications 1 ou 2, dans lequel les zones de séparation (4) sont formées par des zones semi-isolantes dans le matériau semi-conducteur.

6. Transistor de puissance selon la revendication 1, dans lequel les zones de séparation (4) sont formées par des pièces d'écartement, qui limitent tout autour les complexes émetteur-base (3) et qui sont en matériau diélectrique.

7. Transistor de puissance selon l'une des revendications 1 à 6, disposé sur un substrat (10) semi-isolant, dans lequel, passant sur les deux côtés des lignes d'alimentation de base (1) et parallèlement aux lignes d'alimentation de base (1), d'autres zones de séparation (5) sont présentes, qui s'étendent jusqu'au substrat (10) semi-isolant,
passant sur les deux côtés des lignes d'alimentation d'émetteur (2) et parallèlement aux lignes d'alimentation d'émetteur (2), d'autres zones de séparation (5) sont présentes
et ces autres zones de séparation sont disposées à chaque fois entre deux complexes émetteur-base (3) consécutifs le long d'une ligne d'alimentation de base (1) et atteignent à chaque fois les zones de séparation (4) entourant ces complexes émetteur-base.

8. Transistor de puissance selon la revendication 7, dans lequel les autres zones de séparation (5) sont conçues de la même manière que les zones de séparation (4).

9. Transistor de puissance selon la revendication 7, dans lequel les secteurs entourés par les autres zones de séparation (5) sont remplis d'un matériau diélectrique sur toute leur surface.
